# EUROPEAN PATENT SPECIFICATION

(11) **EP 3 604 630 B1**
(45) Date of publication and mention of the grant of the patent: **21.02.2024**
(21) Application number: 18777279.3
(22) Date of filing: 30.03.2018
(51) Int. Cl.: C30B 29/20, C30B 15/34, F28F 1/40, F28F 21/00, C30B 29/66, F28F 21/08, F28D 7/10, F28F 13/00

(54) **TUBULAR SAPPHIRE MEMBER, HEAT EXCHANGER, SEMICONDUCTOR MANUFACTURING DEVICE AND METHOD FOR MANUFACTURING TUBULAR SAPPHIRE MEMBER**
RÖHRENFÖRMIGES SAPHIRELEMENT, WÄRMETAUSCHER, HALBLEITERHERSTELLUNGSVORRICHTUNG UND VERFAHREN ZUR HERSTELLUNG EINES RÖHRENFÖRMIGEN SAPHIRELEMENTS
ÉLÉMENT DE SAPHIR TUBULAIRE, ÉCHANGEUR DE CHALEUR, DISPOSITIF DE FABRICATION DE SEMI-CONDUCTEURS ET PROCÉDÉ DESTINÉ À FABRIQUER UN ÉLÉMENT DE SAPHIR TUBULAIRE

(30) Priority: 30.03.2017 JP 2017066689
(43) Date of publication of application: 05.02.2020
(73) Proprietor: KYOCERA Corporation, Kyoto 612-8501 (JP)
(72) Inventor: SAKANO, Ichiro, Kyoto-shi, Kyoto 612-8501 (JP); YUKIHIRO, Keiji, Kyoto-shi, Kyoto 612-8501 (JP)
(74) Representative: Viering, Jentschura & Partner mbB Patent- und Rechtsanwälte
(86) International application number: PCT/JP2018/013831
(87) International publication number: WO 2018/181981

(56) References cited:
- WO-A1-2017/196952
- JP-A- S5 826 097
- JP-A- H07 165 485
- JP-A- 2003 327 495
- JP-A- 2016 088 820
- US-A- 3 868 228
- KURLOV V N ET AL: "EFG growth of sapphire tubes upto 85mm in diameter", JOURNAL OF CRYSTAL GROWTH, ELSEVIER, AMSTERDAM, NL, vol. 187, no. 1, 15 April 1998 (1998-04-15), pages 107-110, XP004119783, ISSN: 0022-0248, DOI: 10.1016/S0022-0248(97)00846-4
- GURJIYANTS P A ET AL: "Effect of growth conditions on the strength of shaped sapphire", JOURNAL OF CRYSTAL GROWTH, ELSEVIER, AMSTERDAM, NL, vol. 198-199, 1 March 1999 (1999-03-01), pages 227-231, XP004170857, ISSN: 0022-0248, DOI: 10.1016/S0022-0248(98)01131-2

## Description

### TECHNICAL FIELD

The present disclosure relates to a tubular sapphire member, a heat exchanger, a semiconductor manufacturing device, and a method for manufacturing the tubular sapphire member.

### BACKGROUND ART

A tubular member made of sapphire has excellent chemical resistance, so that it is used for circulating a chemical solution. In addition, sapphire has relatively high thermal conductivity, so it is also applied to exchange heat. A method for manufacturing a tubular member consisting of a single crystal is described in Patent Documents 1, 2. Moreover, US 3,868,228 A discloses a tubular sapphire member according to the preamble of claim 1.

### RELATED ART DOCUMENT

### PATENT DOCUMENT

Patent Document 1: Japanese Unexamined Patent Publication No. 58-26097
Patent Document 2: Japanese Translation of PCT Publication No. 2004-525852

### SUMMARY OF THE INVENTION

A tubular sapphire member of the present disclosure which is a tubular body made of sapphire, including: an outer wall extending in an axial direction; a plurality of through holes extending in the axial direction; and one or more partition walls extending in the axial direction and dividing the plurality of through holes, wherein the axial direction is parallel to a c-axis of sapphire, and at least one of the partition walls extends from a central axis toward the outer wall and is connected with the outer wall in a front view seen in the axial direction, and an extending direction of the partition wall is parallel to either an a-axis or an m-axis of sapphire.

### BRIEF DESCRIPTION OF THE DRAWINGS

Fig. 1 is a front view of a tubular sapphire member according to a first embodiment seen in an axial direction.
Fig. 2 is a front view according to a second embodiment.
Fig. 3 is a front view according to a third embodiment.
Fig. 4 is a front view according to a fourth embodiment.
Fig. 5 is a front view according to a fifth embodiment.
Fig. 6 is a front view according to a sixth embodiment.
Fig. 7 is a front view according to a seventh embodiment.
Fig. 8 is a top view of a mold used for manufacturing a tubular sapphire member.
Fig. 9 is a longitudinal sectional view taken along a line A-A' in Fig. 8.
Fig. 10 is a view showing a crystal structure of sapphire.

### EMBODIMENTS FOR CARRYING OUT THE INVENTION

A tubular sapphire member of the present disclosure will be described with reference to the drawings.

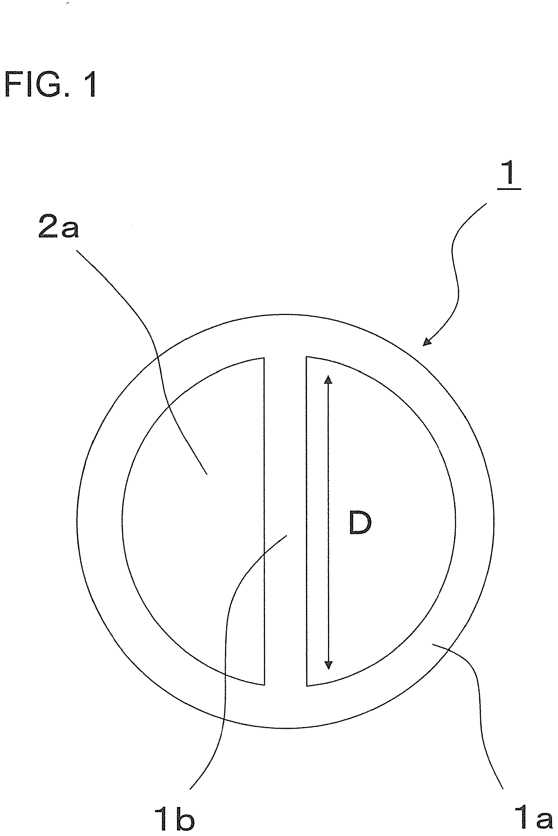

Fig. 1 is a front view of a tubular sapphire member 1 according to a first embodiment seen in an axial direction.

As shown in Fig. 1, the tubular sapphire member 1 includes an outer wall 1a and a partition wall 1b separating a plurality of through holes 2a. A depth direction in Fig. 1 of the tubular sapphire member 1 is an axial direction The outer wall 1a and the partition wall 1b extend in the axial direction. The tubular sapphire member 1 includes the plurality of annularly disposed through holes 2a each having the same shape in a front view as viewed in the axial direction.

Note that sapphire is a single crystal of aluminum oxide, and the tubular sapphire member 1 of the present disclosure is particularly suitable for applications where heat resistance and corrosion resistance are required. Further, since the tubular sapphire member 1 has translucency, it is possible to observe fluid flowing through the through holes 2a, and to transfer heat to the fluid not only by thermal conduction but also by thermal radiation. Note that, in the present disclosure, the "tubular" is a shape provided with through holes 2a extending in the axial direction. The tubular sapphire member 1 may have a shape whose axial length is shorter than an outer diameter (tubular plate).

In the tubular sapphire member 1 of the present disclosure, the axial direction of the outer wall 1a and the partition wall 1b is parallel to a c-axis of sapphire. The partition wall 1b extends from a central axis toward the outer wall 1a and is connected with the outer wall 1a in a front view seen in the axial direction, and an extending direction of the partition wall 1b is parallel to either an a-axis or an m-axis of sapphire. The central axis means a virtual axis parallel to the axial direction and passing through a center of gravity of a cross section of an outer peripheral surface of the tubular sapphire member 1 in a front view seen in the axial direction. For example, when the cross section has a circular shape, a virtual axis parallel to the axial direction and passing through a central position of the circle is the central axis.

"The through holes 2a have the same shape along the axial direction" means that the through holes 2a extend in the axial direction with substantially the same shape, and sizes of the through holes 2a may be partially changed.

Since the tubular sapphire member 1 of the present disclosure includes the partition wall 1b extending towards and connected with the outer wall 1a, the tubular sapphire member 1 has higher strength as a structure than a tubular member having only one through hole. Moreover, in the partition wall 1b, since a relationship between a crystal orientation of sapphire and the partition wall 1b satisfies the above-described configuration, the tubular sapphire member 1 is difficult to break and has excellent reliability. In other words, by making the axial direction of the tubular sapphire member 1 parallel to the c-axis of sapphire and making an extending direction D of the partition wall 1b parallel to either the a-axis or the m-axis of sapphire, the tubular sapphire member 1 that is difficult to break is formed.

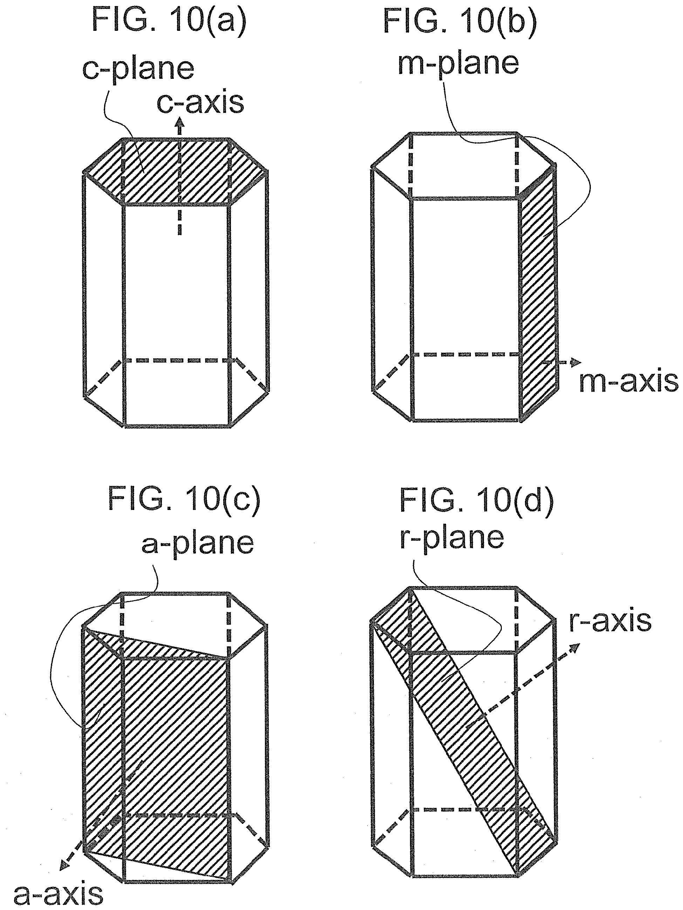

Hereinafter, the reason why the strength of the tubular sapphire member 1 as a structure is increased by adopting such a structure will be described. Fig. 10 shows a crystal structure of sapphire. As shown in Figs. 10(a) to 10(d), the sapphire has crystal planes such as a c-plane, an m-plane, an a-plane, an r-plane, and the like as typical crystal planes.

The sapphire has different mechanical strength depending on a difference in direction between the crystal plane and the crystal axis. Table 1 shows results of a three-point bending strength test according to JIS R 1601 on sapphire samples in which a plane orientation of a main surface and an axis orientation of a long side of the main surface are variously selected. Each sample has dimensions of 4 mm in width, 40 mm in length, and 3 mm in thickness, a surface is ground with a diamond grindstone, a surface roughness (Ra) is about 0.5 µm, and a distance between supporting points supporting the sample is 30 mm.

**[Table 1]**

| |
|---|
| Sample No. |
| Plane orientation |
| a-plane |
| c-plane |
| m-plane |
| r-plane |
| Long axis orientation |
| c-axis |
| m-axis |
| a-axis |
| Bending strength (MPa) |

As shown in Table 1, the three-point bending strength of a test piece is different in the range of 410 MPa to 960 MPa. When the axis orientation of the long side of the main surface is the c-axis and the plane orientation of the main surface is the a-plane perpendicular to the a-axis of the crystal, the strength of the test piece is maximum, and a strength of 960 MPa is shown. In addition, when the axis orientation of the long side of the main surface is the c-axis and the plane orientation of the main surface is the m-plane perpendicular to the m-axis of the crystal, a strength of 700 MPa is shown.

In other words, when the extending direction D of the partition wall 1b orthogonal to the axial direction of the partition wall 1b is parallel to either the a-axis or the m-axis of sapphire, the partition wall 1b is relatively strong. Therefore, the tubular sapphire member 1 improves reliability as a structural member.

Note that, when the extending direction D of the partition wall 1b orthogonal to the axial direction of the partition wall 1b is parallel to the a-axis, the partition wall 1b has particularly high strength. For example, the tubular sapphire member 1 shown in Fig. 1 can be suitably used in applications where compression force is applied to the tubular sapphire member 1 along a vertical direction shown in Fig. 1. Further, when the extending direction D of the partition wall 1b orthogonal to the axial direction of the partition wall 1b is parallel to the m-axis, a region parallel to the a-axis with high strength is present in the outer wall 1a. In this case, the overall strength of the outer wall 1a is also high, and the tubular sapphire member 1 can be suitably used in applications where force is applied in an isobaric manner.

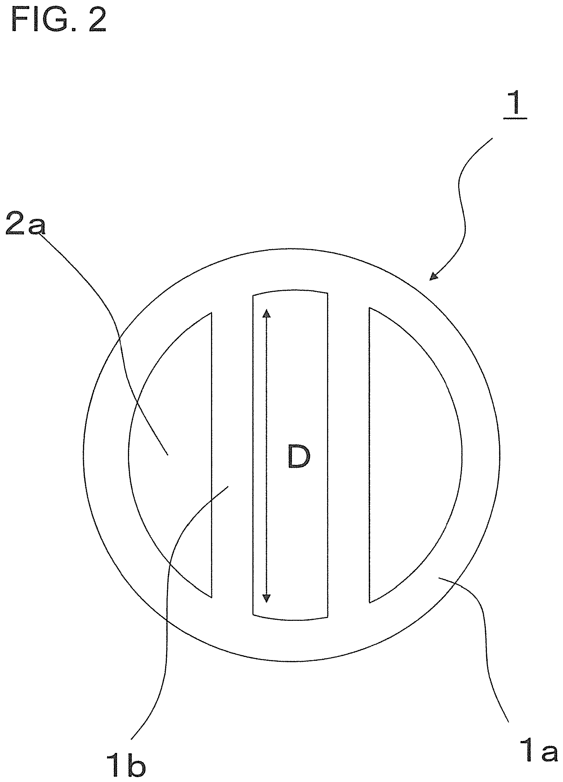

Although Fig. 1 shows an example in which one partition wall 1b is provided, as shown in Fig. 2 showing a second embodiment, there may be a plurality of partition walls 1b disposed to face in the same direction. In an example of Fig. 2, three through holes 2a are provided by disposing two partition walls 1b in a space surrounded by an outer wall 1a. In the embodiments shown in Figs. 1 and 2, in particular, deformation or breakage hardly occurs with respect to force along the vertical direction in Figs. 1 and 2.

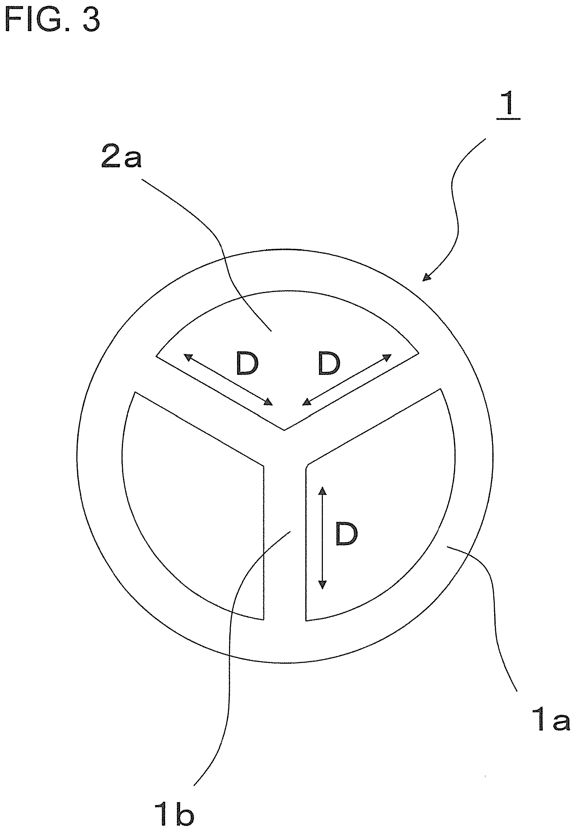

Also, for example, as shown in Fig. 3 showing a third embodiment, even in a case where three through holes 2a are provided by disposing partition walls 1b extending in directions away from a central axis, extending directions D of the partition walls 1b orthogonal to an axial direction of the partition walls 1b can be parallel to either an a-axis or an m-axis of sapphire.

In the example of Fig. 3, three partition walls 1b having an angle of 120° between the partition walls 1b are connected in the vicinity of the central axis of the tubular sapphire member 1. In this example, in the tubular sapphire member 1, three through holes 2a separated by the partition walls 1b are annularly disposed along an inner periphery of an outer wall 1a. As described above, when the angle between the partition walls 1b is 120°, for all the partition walls 1b, the extending direction D of the partition wall 1b can be made parallel to the a-axis or the m-axis of sapphire.

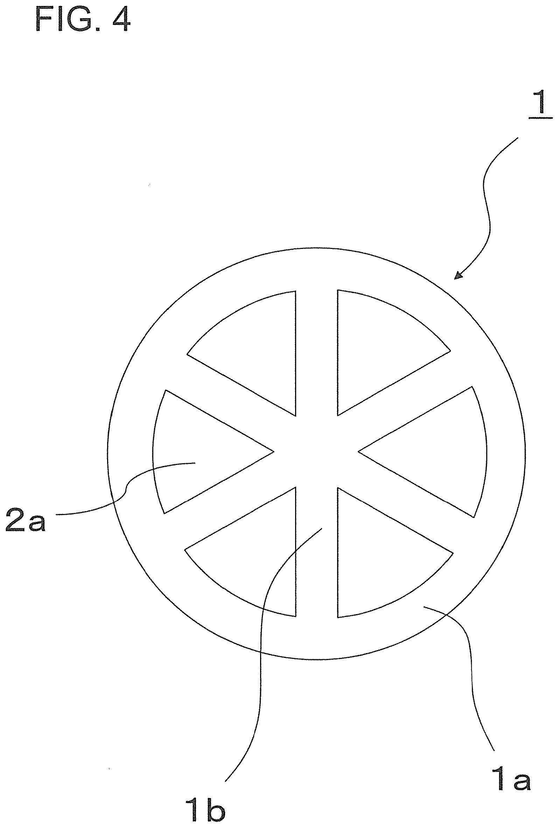

Also, as shown in Fig. 4 showing a fourth embodiment, when an angle between partition walls 1b is 60°, for all the partition walls 1b, an extending direction D of the partition wall 1b can be similarly parallel to an a-axis or an m-axis of sapphire.

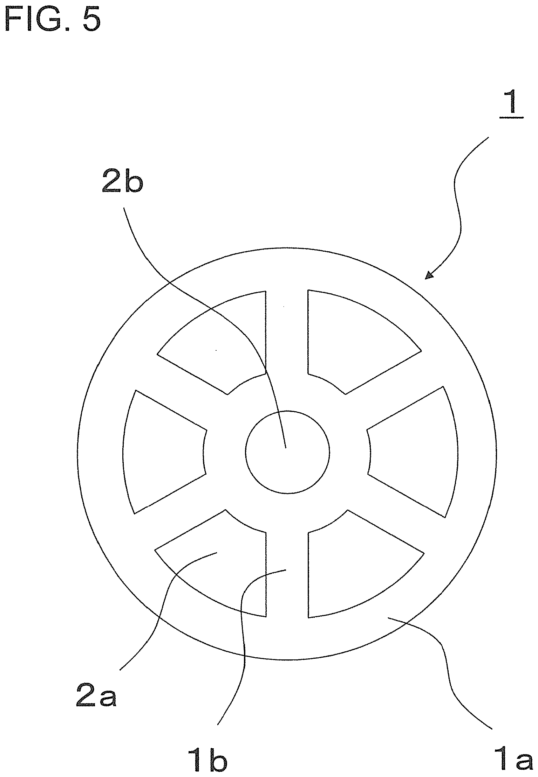

Further, as shown in Fig. 5 showing a fifth embodiment, one through hole 2 is disposed at a position overlapping a central axis, and a surrounding outer wall 1c surrounding the through hole 2 disposed at the position overlapping the central axis may be provided in a front view seen in an axial direction. In other words, the through hole surrounded by the surrounding outer wall 1c may be further provided at a position overlapping the axial direction. Hereinafter, the through hole surrounded by the surrounding outer wall 1c will be described as a second through hole 2b, and the other through hole will be described as a first through hole 2a. In the example shown in Fig. 5, the second through hole 2b is disposed at the position overlapping the central axis of the tubular sapphire member 1, and a plurality of the first through holes 2a surround the periphery of the second through hole 2b.

According to the structure shown in Fig. 5, that is, by disposing the surrounding outer wall 1c so as to provide the second through hole 2b at the center of the tubular sapphire member 1, mechanical strength in a region near the central axis becomes relatively high.

Further, heat can be exchanged between the one second through hole 2b and the plurality of first through holes 2a. When the tubular sapphire member 1 is used in a heat exchanger application, for example, one sapphire member can configure a plurality of types of heat exchange paths, and heat exchange efficiency can be made relatively high.

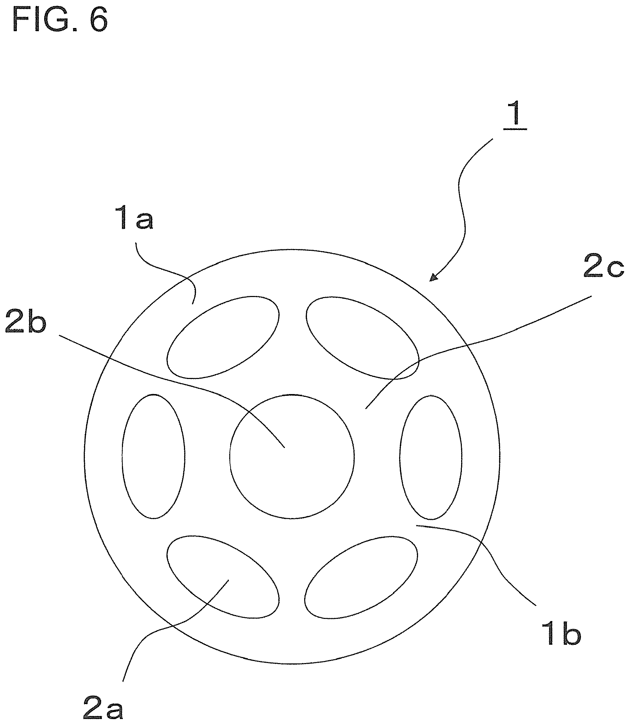

Further, as shown in Fig. 6 showing a sixth embodiment, a second through hole 2b may be located at a center of a tubular sapphire member 1, and first through holes 2a having an elliptical shape may surround the second through hole 2b. With such a structure, a portion where stress concentrates can be eliminated as compared to a case where the first through hole 2a has a corner.

A shape of the first through hole 2a may be circular, and as shown in Figs. 1 to 6, the shape of the first through hole 2a may be non-circular. As described above, when the shape of the first through hole 2a is non-circular, an area of the first through hole 2a with respect to a volume of the first through hole 2a is larger than in the case of the circular shape, so heat exchange efficiency can be increased. Examples of non-circular shapes include an oval, a square, and a shape in which a plurality of grooves is formed on an inner wall of a first through hole 2a. If shapes in cross sections of these through holes 2 have corners, the corners may be rounded.

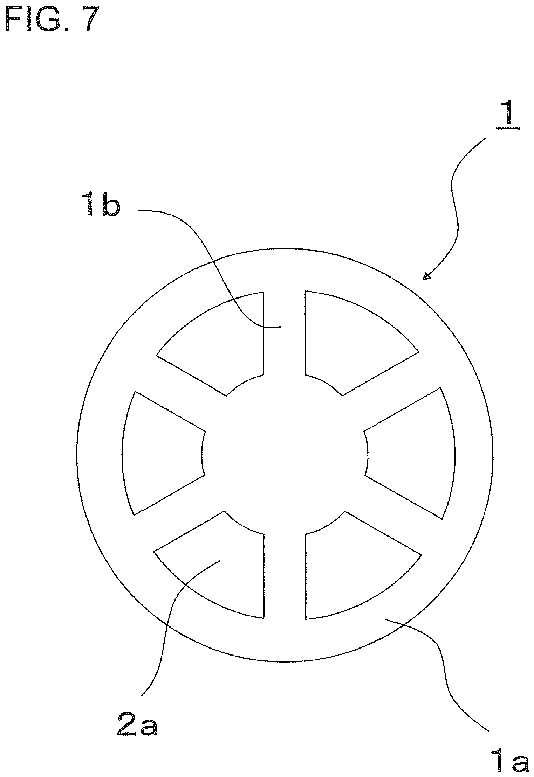

Further, as shown in Fig. 7 showing a seventh embodiment, in the embodiment in which all partition walls 1b are connected in the vicinity of a central axis, an area of a columnar body of a connection portion of the partition walls 1b in a front view seen in an axial direction may be made relatively large. In this case, a region including the central axis has relatively high mechanical strength.

In addition, as shown in Figs. 1, 3, and 4, the first through holes 2a may have a circular equal shape in a front view as seen in a penetration direction. Further, as shown in Figs. 5 and 7, the first through holes 2a may have an annular equal shape in a front view as seen in a penetration direction. As described above, when the shape of the first through holes 2a is the circular equal shape or the annular equal shape, mechanical strength distribution along an outer peripheral line of the outer wall 1a becomes small in the front view along the axial direction. In this case, even when pressure is generally applied to the tubular sapphire member 1, there is less deformation, cracking, or the like.

Further, in a front view seen in the axial direction, it is preferable to dispose the first through holes 2a in point symmetry with the central axis as a symmetry center. With such a structure, the mechanical strength distribution along the outer peripheral line of the outer wall 1a in the front view along the axial direction is smaller than in a case where first through holes 2a are randomly provided.

The tubular sapphire member 1 described above is used as a flow passage member for circulating gas or liquid. For example, the tubular sapphire member 1 can also be used as a component of a semiconductor manufacturing device in which a reaction gas or the like for producing a semiconductor element is circulated. Further, the tubular sapphire member 1 can be used not only for passing gas and liquid but also used as a heat exchanger for performing heat exchange between passing gas and fluid.

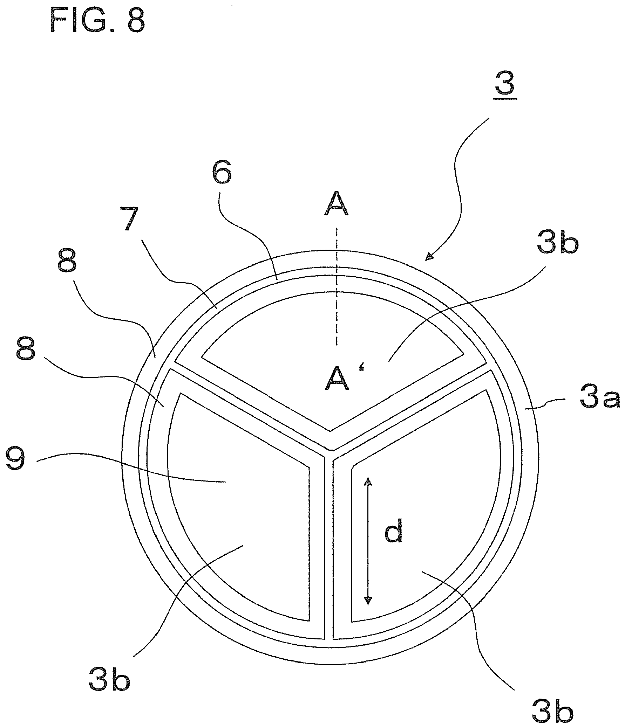

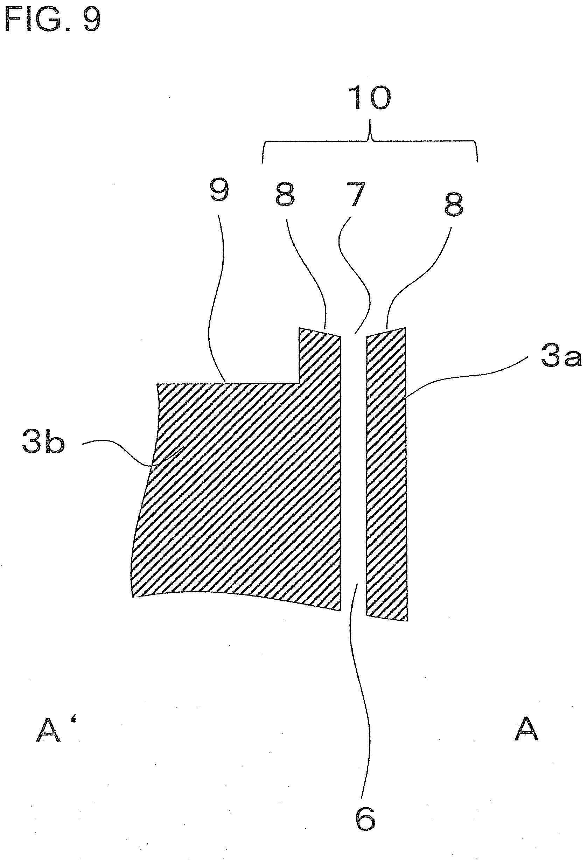

Hereinafter, a method for manufacturing the tubular sapphire member 1 will be described with reference to Figs. 8 and 9.

In the method for manufacturing the tubular sapphire member 1, a mold 3 for determining a shape of the tubular sapphire member 1 is used. Fig. 8 is a schematic view of the mold 3 in a top view. Molten sapphire melt is disposed on a part of an upper surface of the mold, and a sapphire crystal as a seed (hereinafter referred to as a seed crystal) is brought into contact with the sapphire melt. Then, by pulling up the seed crystal in a front direction in Fig. 8, a sapphire crystal to be the tubular sapphire member 1 can be grown.

Moreover, when the seed crystal is brought into contact with the sapphire melt, by aligning a crystal orientation of the seed crystal and pulling up the seed crystal, the tubular sapphire member 1 of the present disclosure can be manufactured in which the axial direction is parallel to the c-axis of sapphire and the extending direction D of a partition wall 1b orthogonal to the axial direction of the partition wall 1b is parallel to either the a-axis or the m-axis of sapphire.

The method for manufacturing the tubular sapphire member 1 of the present disclosure is described below in detail.

The method for manufacturing the tubular sapphire member 1 of the present disclosure includes: preparing a mold 3 having an opening 7 and crystal growth surfaces 8 at portions corresponding to the outer wall 1a and the partition walls 1b in the tubular sapphire member 1 described above; aligning the mold 3 so that a pulling direction is a c-axis of the seed crystal and the extending direction D of the partition wall 1b orthogonal to the pulling direction is parallel to either an a-axis or an m-axis of the seed crystal; bringing the seed crystal into contact with sapphire melt present in the opening 7 of the mold 3; and pulling up the seed crystal for growth.

An EFG apparatus used to manufacture the tubular sapphire member 1 includes: a crucible for containing sapphire melt obtained by heating a sapphire raw material; the mold 3 for determining a cross-sectional shape of the tubular sapphire member 1 to be manufactured; heating means for heating the crucible, the sapphire melt, and the mold 3; and a crystal pulling mechanism.

Moreover, a sapphire crystal can be grown by bringing the seed crystal attached to a lower end of the pulling mechanism into contact with the sapphire melt and pulling up the seed crystal. The heating means is, for example, an induction heating coil placed around the crucible.

As a material of the crucible, high melting point materials, such as Mo, Ir, and W, are used suitably. In the present embodiment, a crucible made of Mo was used. If cross-sectional shapes of an inner peripheral surface and an outer peripheral surface of the crucible are circular, the crucible may be easily heated uniformly by the heating means.

The EFG apparatus may further include an imaging unit, an image processing unit, and a display unit, which are means for observing the tubular sapphire member 1, the sapphire melt, the mold 3, and the seed crystal during the manufacture.

Fig. 8 is a schematic view of the mold 3 for producing the tubular sapphire member 1 having the three partition walls 1b shown in Fig. 3 in the top view. Further, Fig. 9 is a longitudinal sectional view of the mold 3 in an A-A' portion in Fig. 8.

The mold 3 includes an annular mold 3a located outside and three inner molds 3b disposed inside the annular mold 3a. In the top view, a slit 6 which is a space is present between the annular mold 3a and the three inner molds 3b. Moreover, the slit 6 which is the space also exists between the adjacent inner molds 3b. Also, these slits 6 are all connected. The slit 6 is in communication with an upper surface of the mold 3, and a lower end of the slit 6 is immersed in melt existing at the lower end of the slit 6. The slit 6 has a function of supplying the melt to the opening 7 of the slit 6 by capillarity, and sapphire melt will exist in the opening 7 at the time of manufacture.

Also, portions 8 of the upper surface of the mold 3 are disposed so as to surround the opening 7. Further, a recess 9 is formed on the upper surface of the mold 3 at a position corresponding to the through hole 2a of the tubular sapphire member 1.

A shape of the upper surface of the mold 3 is summarized is as follows. The recess 9 is formed on the upper surface of the mold 3, the slit 6 is disposed, and the portions 8 of the upper surface are disposed to surround the slit 6. Hereinafter, the portion 8 of the upper surface surrounding the slit 6 is referred to as a crystal growth surface 8.

Further, in the upper surface of the mold 3, a portion excluding the recess 9, that is, a region where the opening 7 of the slit 6 and the crystal growth surfaces 8 are combined is referred to as a crystal growth region 10. The crystal growth region 10 substantially matches the cross-sectional shape of the tubular sapphire member 1 shown in Fig. 3. Of the upper surface of the mold 3 shown in Fig. 9, the crystal growth surfaces 8 have slopes which become lower toward the slit 6, but the crystal growth surfaces 8 may be horizontal surfaces.

In the manufacturing process, the sapphire melt reaches the opening 7 through the slit 6 and extends to the crystal growth surfaces 8. In other words, the sapphire melt exists over the crystal growth region 10. By pulling up the seed crystal after the seed crystal is brought into contact with the sapphire melt, it is possible to manufacture the tubular sapphire member 1 whose cross-sectional shape substantially matches the crystal growth region 10.

In order to manufacture the tubular sapphire member 1 of the present disclosure, the mold 3 having the crystal growth region 10 is prepared in portions corresponding to the outer wall 1a and the partition wall 1b of the tubular sapphire member 1 described above.

Also, in order to manufacture the tubular sapphire member 1 of the present disclosure, the seed crystal is prepared. The seed crystal is made of sapphire and the pulling direction is the c-axis direction. The cross-sectional shape of the seed crystal may be substantially the same as that of the crystal growth region 10. This seed crystal can be prepared by processing a mass of sapphire.

Next, alignment between a crystal orientation of the seed crystal and the mold 3 is performed so that a direction d which is a direction perpendicular to the pulling direction of the tubular sapphire member 1 and in which, in the prepared mold 3, the crystal growth region 10 of the portion to be the partition wall 1b is connected to the crystal growth region of the portion to be the outer wall 1a is either the a-axis or the m-axis of the seed crystal.

Then, a sapphire raw material made of alumina powder is heated to, for example, 2080°C to form the sapphire melt, and the sapphire melt is supplied to the crystal growth region 10 through the slit 6 and the opening 7. Then, after the seed crystal is brought into contact with the sapphire melt, the seed crystal is pulled up to grow the sapphire crystal. Thus, the tubular sapphire member 1 of the present disclosure can be obtained. Note that a portion close to the seed crystal and a portion at the end of the crystal growth may contain crystal disorder and bubbles, and therefore, they may be removed by processing.

In addition, post-processing such as polishing, annealing, and etching may be appropriately performed. Note that, in the above example, the seed crystal has substantially the same shape as the crystal growth region 10, but for example, a plurality of seed crystals may be used in combination.

In the example shown in Fig. 8, the opening 7 is formed continuously to the portions corresponding to the outer wall 1b and the partition wall 1b of the tubular sapphire member 1. Even if the opening 7 does not exist in part, as long as the sapphire melt is shaped so as to be pulled up to the crystal growth surfaces 8, the opening 7 may not be present in part.

Also, in the present disclosure, description of being parallel to the axis of sapphire does not mean only completely parallel, and for example, an angular deviation of about 10° is acceptable.

As mentioned above, although the embodiments of the present invention have been described, the present invention is not limited to the above-mentioned embodiments. Various improvements and changes may be made in a range which does not deviate from the scope of the present invention as defined by the claims. For example, although the outer peripheral shape of the tubular sapphire member 1 is circular, it may be polygonal, and like the partition wall 1b, in the outer wall 1a, the direction perpendicular to the axial direction may be parallel to either the a-axis or the m-axis of sapphire.

### DESCRIPTION OF THE REFERENCE NUMERAL

- 1:: Tubular sapphire member
- 1a:: Outer wall
- 1b:: Partition wall
- 2a:: Through hole (first through hole)
- 2b:: Surrounding through hole (second through hole)
- 3:: Mold
- 3a:: Annular mold
- 3b:: Inner mold
- 6:: Slit
- 7:: Opening
- 8:: Crystal growth surface
- 9:: Recess
- 10:: Crystal growth region
- D:: Extending direction

## Claims

1. A tubular sapphire member (1) which is a tubular body made of sapphire, comprising:
an outer wall (1a) extending in an axial direction, wherein the axial direction is parallel to a c-axis of sapphire;
**characterized by**
a plurality of through holes (2a, 2b) extending in the axial direction; and
one or more partition walls (1b) extending in the axial direction and dividing the plurality of through holes (2a),
wherein at least one of the partition walls (1b) extends from a central axis toward the outer wall (1a) and is connected with the outer wall (1a) in a front view seen in the axial direction, and an extending direction (D) of the partition wall (1b) is parallel to either an a-axis or an m-axis of sapphire.

2. The tubular sapphire member (1) according to claim 1, wherein one of the through holes (2b) is disposed at a position overlapping with the central axis, the member further comprising:
a surrounding outer wall (1a) surrounding the through hole (2b) disposed at the position overlapping with the central axis in the front view seen in the axial direction.

3. The tubular sapphire member (1) according to claim 1 or 2, wherein the through hole (2a) is non-circular in the front view seen in the axial direction.

4. The tubular sapphire member (1) according to any of claims 1 to 3, wherein the plurality of through holes (2a) is annularly disposed along an outer periphery of the outer wall (1a) in the front view seen in the axial direction.

5. The tubular sapphire member (1) according to claim 4, wherein the plurality of annularly disposed through holes (2a) each having a same shape in the front view seen in the axial direction is included.

6. A heat exchanger comprising the tubular sapphire member (1) according to any of claims 1 to 5 as a flow passage member.

7. A semiconductor manufacturing device comprising the heat exchanger according to claim 6.

8. A method for manufacturing a tubular sapphire member (1) which is a tubular body made of sapphire including:
an outer wall (1a) extending in an axial direction;
a plurality of through holes (2a, 2b) extending in the axial direction; and
one or more partition walls (1b) extending in the axial direction and dividing the plurality of through holes (2a),
wherein the axial direction is parallel to a c-axis of sapphire, and
at least one of the partition walls (1b) extends from a central axis toward the outer wall (1a) and is connected with the outer wall (1a) in a front view seen in the axial direction, and the extending direction (D) is parallel to either an a-axis or an m-axis of sapphire,
the method comprising:
a step of preparing a mold (3) having a crystal growth region (10) in portions corresponding to the outer wall (1a) and the partition wall (1b) of the tubular sapphire member (1);
a step of preparing a seed crystal made of sapphire;
a step of aligning a crystal orientation of the seed crystal and the mold (3) so that a pulling direction is parallel to a c-axis of the seed crystal and the extending direction (D) of the partition wall (1b) is either an a-axis or an m-axis of the seed crystal;
a step of bringing the seed crystal into contact with sapphire melt present in the crystal growth region (10) of the mold (3) in an aligned state in the aligning step; and
a step of pulling up the seed crystal to grow a crystal.

## Patentansprüche

1. Röhrenförmiges Saphirelement (1), das ein röhrenförmiger Körper aus Saphir ist, aufweisend:
eine Außenwand (1a), die sich in einer axialen Richtung erstreckt, wobei die axiale Richtung parallel zu einer c-Achse von Saphir ist,
**gekennzeichnet durch**
eine Mehrzahl von Durchgangslöchern (2a, 2b), die sich in der axialen Richtung erstrecken, und
eine oder mehrere Trennwände (1b), die sich in der axialen Richtung erstrecken und die Mehrzahl von Durchgangslöchern (2a) unterteilen,
wobei mindestens eine der Trennwände (1b) ) in einer Frontansicht, in der axialen Richtung gesehen, sich von einer zentralen Achse in Richtung der Außenwand (1a) erstreckt und mit der Außenwand (1a) verbunden ist, und eine Erstreckungsrichtung (D) der Trennwand (1b) parallel zu entweder einer a-Achse oder einer m-Achse von Saphir ist.

2. Röhrenförmiges Saphirelement (1) gemäß Anspruch 1, wobei eines der Durchgangslöcher (2b) an einer Position angeordnet ist, die mit der Mittelachse überlappt, wobei das Element ferner aufweist:
eine umgebende Außenwand (1a), die das Durchgangsloch (2b) umgibt, das an der Position angeordnet ist, die in der Frontansicht, in der axialen Richtung gesehen, mit der Mittelachse überlappt.

3. Röhrenförmiges Saphirelement (1) gemäß Anspruch 1 oder 2, wobei das Durchgangsloch (2a) in der Frontansicht, in der axialen Richtung gesehen, nicht kreisförmig ist.

4. Röhrenförmiges Saphirelement (1) gemäß irgendeinem der Ansprüche 1 bis 3, wobei die Mehrzahl von Durchgangslöchern (2a) in der Frontansicht, in der axialen Richtung gesehen, ringförmig entlang einer äußeren Peripherie der Außenwand (1a) angeordnet ist.

5. Röhrenförmiges Saphirelement (1) gemäß Anspruch 4,
wobei die Mehrzahl von ringförmig angeordneten Durchgangslöchern (2a) enthalten ist, die in der Frontansicht, in der axialen Richtung gesehen, jeweils eine gleiche Form haben.

6. Wärmetauscher, der das röhrenförmigen Saphirelement (1) gemäß irgendeinem der Ansprüche 1 bis 5 als ein Strömungsdurchgangselement aufweist.

7. Halbleiterherstellungsvorrichtung, die den Wärmetauscher gemäß Anspruch 6 aufweist.

8. Verfahren zum Herstellen eines rohrförmigen Saphirelements (1), das ein röhrenförmiger Körper aus Saphir ist, aufweisend:
eine Außenwand (1a), die sich in axialer Richtung erstreckt,
eine Mehrzahl von Durchgangslöchern (2a, 2b), die sich in der axialen Richtung erstrecken, und
eine oder mehrere Trennwände (1b), die sich in der axialen Richtung erstrecken und die Mehrzahl von Durchgangslöchern (2a) unterteilen,
wobei die axiale Richtung parallel zu einer c-Achse des Saphirs ist und
wobei mindestens eine der Trennwände (1b) in einer Frontansicht, in der axialen Richtung gesehen, sich von einer zentralen Achse in Richtung der Außenwand (1a) erstreckt und mit der Außenwand (1a) verbunden ist, und eine Erstreckungsrichtung (D) der Trennwand (1b) parallel zu entweder einer a-Achse oder einer m-Achse von Saphir ist
das Verfahren aufweisend:
einen Schritt des Bereitstellens einer Form (3), die einen Kristallwachstumsbereich (10) in Abschnitten, die der Außenwand (1a) und der Trennwand (1b) des röhrenförmigen Saphirelements (1) entsprechen, aufweist,
einen Schritt des Bereitstellens eines Impfkristalls aus Saphir,
einen Schritt des Ausrichtens einer Kristallorientierung des Impfkristalls und der Form (3), so dass eine Ziehrichtung parallel zu einer c-Achse des Impfkristalls ist und die Erstreckungsrichtung (D) der Trennwand (1b) entweder eine a-Achse oder eine m-Achse des Impfkristalls ist,
einen Schritt des In-Kontakt-Bringens des Impfkristalls mit einer im Kristallwachstumsbereich (10) der Form (3) vorhandenen Saphirschmelze in einem ausgerichteten Zustand im Ausrichtungsschritt und
einen Schritt des Hochziehens des Impfkristalls, um einen Kristall wachsen zu lassen.

## Revendications

1. Elément tubulaire en saphir (1) qui est un corps tubulaire en saphir, comprenant:
une paroi extérieure (1a) s'étendant dans une direction axiale, la direction axiale étant parallèle à l'axe c du saphir,
**caractérisé par**
une pluralité de trous de passage (2a, 2b) s'étedant dans la direction axiale et
une ou plusieurs cloisons de séparation (1b) s'étendant dans la direction axiale et divisant la pluralité de trous de passage (2a),
dans lequel au moins une des cloisons de séparation (1b) s'étend d'un axe central vers la paroi extérieure (1a) et est reliée à la paroi extérieure (1a) dans une vue de face, vue dans la direction axiale, et une direction d'extension (D) de la cloison de séparation (1b) est parallèle soit à l'axe a ou à l'axe m du saphir.

2. Elément tubulaire en saphir (1) selon la revendication 1, dans lequel l'un des trous de passage (2b) est disposé à une position enchevauchant l'axe central, l'élément comprenant en outre:
une paroi extérieure environnante (1a) environnant le trou de passsage (2b) disposé à la position enchevauchant l'axe central dans la vue de face, vue dans la direction axiale.

3. L'élément tubulaire en saphir (1) selon la revendication 1 ou 2, dans lequel le trou de passage (2a) n'est pas circulaire dans la vue de face, vue dans la direction axiale.

4. L'élément tubulaire en saphir (1) selon l'une quelconque des revendications 1 à 3, dans lequel la pluralité de trous de passage (2a) est disposée annulairement le long d'une périphérie extérieure de la paroi extérieure (1a) dans la vue de face, vue dans la direction axiale.

5. Elément tubulaire en saphir (1) selon la revendication 4, dans lequel la pluralité de trous de passage (2a) disposés annulairement ayant chacun la même forme dans la vue de face, vue dans la direction axiale, est incluse.

6. Échangeur de chaleur comprenant l'élément tubulaire en saphir (1) selon l'une quelconque des revendications 1 à 5 en tant qu'élément de passage de flux.

7. Dispositif de fabrication de semi-conducteurs comprenant l'échangeur de chaleur selon la revendication 6.

8. Procédé de fabrication d'un élément tubulaire en saphir (1) qui est un corps tubulaire en saphir comprenant:
une paroi extérieure (1a) s'étendant dans une direction axiale,
une pluralité de trous de passage (2a, 2b) s'étendant dans la direction axiale et
une ou plusieurs cloisons de séparation (1b) s'étendant dans la direction axiale et divisant la pluralité de trous de passage (2a),
dans lequel la direction axiale est parallèle à l'axe c du saphir, et
au moins une des cloisons de séparation (1b) s'étend d'un axe central vers la paroi extérieure (1a) et est reliée à la paroi extérieure (1a) dans une vue de face, vue dans la direction axiale, et la direction d'extension (D) est parallèle soit à l'axe a ou à l'axe m du saphir,
la méthode comprenant:
une étape de préparer un moule (3) ayant une région de croissance cristalline (10) dans des parties correspondant à la paroi extérieure (1a) et à la cloison de séparation (1b) de l'élément tubulaire en saphir (1),
une étape de préparer un cristal en saphir,
une étape d'aligner une orientation cristalline du germe cristallin et du moule (3) de manière qu'une direction de tirage soit parallèle à un axe c du germe cristallin et que la direction d'extension (D) de la cloison de séparation (1b) soit soit un axe a ou un axe m du germe cristallin,
une étape de mettre en contact le germe cristallin avec une fonte de saphir présente dans la région de croissance cristalline (10) du moule (3) dans un état aligné dans l'étape d'aligner et
une étape de tirer vers le haut le germe cristallin pour faire croître un cristal.
